# EUROPEAN PATENT APPLICATION

(11) **EP 2 330 875 A1**
(43) Date of publication of application: **08.06.2011**
(21) Application number: 09009207.3
(22) Date of filing: 15.07.2009
(51) Int. Cl.: H05K 3/12, B41J 11/00

(54) **Method for generating photonically treated printed structures on surfaces, apparatus, and use thereof**

(71) Applicant: Stichting Dutch Polymer Institute, 5612 AB Eindhoven (NL)
(72) Inventor: The designation of the inventor has not yet been filed
(74) Representative: Ackermann, Joachim

(57) **Abstract**

Method for generation of photonically processed surface structures, apparatus therefor and use

Disclosed is a method for generating photonically processed surface patterns on a substrate by inkjet printing the substrate with a photonically active material, for example of electrically conductive particles or of particles of a material that can be converted by irradiation into an electrically conducting material, and by treating the imprinted surface with actinic laser radiation which is emitted from a laser interconnected with the print head of the inkjet printer. The laser radiation causes the photonically curable material to become chemically and/or physically modified.

The process is easy to implement, needs only low energy, is very fast and can be used to generate patterns of functional materials at low cost.

## Description

### Disclosure

Method for generation of photonically processed printed structures on surfaces, apparatus, and use thereof.

This invention relates to the manufacture of photonically processed surface patterns on a substrate surface, preferably of electrically conducting surface patterns, by a simple and efficient method, to an apparatus adapted to carry out this method and to the use of this method for creation of photonically processed surface patterns on a substrate.

Drop-on-demand inkjet printing of metal nanoparticles has gained considerable interest in recent years for the generation of electrically conductive patterns on a substrate or for printing polymers onto a surface (D. Huang, F. Liao, S. Molesa, D. Redinger and V. Subramanian, J. Electrochem. Soc., 2003, 150, G412-G417, and J. B. Szczech, C. M. Megaridis, D. R. Gamota and J. Zhang, IEEE Trans. Electron. Packag. Manuf., 2002, 25, 26-33.) To date, the most common metrhod of printing conductive patterns involves two steps, namely a first step involving the dispensing of a fluid formulation containing electrically conductive particles, such as surface-modified metallic nanoparticles, and then a subsequent second step, where the particles are treated to sinter the particles together to form a continuous pattern through which electrons can be readily transported.

One approach has been to silk-screen print a silver particle paste, and then to sinter the particles afterwards using laser (Y. C. Lin and J. H. Jean, J. Am. Ceram. Soc., 2004, 87, 187-191.) This non-lithographic silkscreen and constrained sintering approach allows for high-resolution conductive features to be printed, but is limited in the sense that a silk screen must be prepared for each circuit pattern, and is therefore not a flexible means of prototyping. It also requires two separate platforms -- one thereof being a silkscreen printing process using one device, and the other one being a laser sintering on another device. Furthermore, the resolution achieved will be limited by how well the pattern is transferred from one system to the next.

Powder bed printing coupled with selective laser sintering is also known (H. Exner, L. Hartwig, A. Streek, M. Horn, S. Klotzer, R. Ebert and P. Regenfuss, DVS Ber., 2007, 241, 153-163; U. Lakshminarayan and K. P. McAlea, Adv. Powder Metall. Part. Mater., 1996, 15/129-115/138; X. Li and L. Shaw Leon, Dent. Mater., 2005, 21, 336-346; W. O'Neill, C. J. Sutcliffe, R. Morgan and K. K. B. Hon, ICALEO'98, Orlando, FL, 1998; D. I. Wimpenny and S. Banerjee, Solid Freeform Fabr. Symp. Proc., 2006, 789-799; and F. E. Wiria, K. F. Leong, C. K. Chua and Y. Liu, Acta Biomater., 2007, 3, 1-12). With this method, a powder layer is deposited on a surface, then sintered in place following a particular pattern. While this method allows for good feature resolution and is currently used as a popular method of rapid prototyping of customized parts, it requires large amounts of the powder, the number of materials is still limited, and is not directly applicable to liquid-based inks.

Inkjet printing of metal particles, such as copper, gold, and silver nanoparticles, has gained considerable interest in recent years as a technique for printing conductive patterns on foils and films (J. Sears, J. Colvin and M. Carter, Mater. Sci. Forum, 2007, 534-536, 1385-1388). Typically, these materials are deposited as a protected nanoparticle suspension, which dries to leave a non-conductive or weakly conductive pattern of nanoparticles behind. In order to achieve good conductivity, this process is typically followed by a sintering process, whereby the nanoparticles are treated to remove the organic material between the nanoparticles, and to melt the particles together, forming a continuous path for electron transport. This sintering or annealing process is typically performed by heating the entire foil in the range from 200 to 300 °C in an oven, by microwave irradiation, or by laser sintering.

While heat sintereing is a generally robust, well-developed technique, it is limited in its application to substrate materials that are able to withstand the high temperatures involved. Microwave sintering is a more recent development, but many materials and devices are incompatible with exposure to microwaves.

Laser sintering enables that the nanoparticle pattern may be selectively sintered, while leaving the surrounding surfaces unperturbed. Since the sintering process is guided by the laser itself, the curing process can be controlled to overlap the deposition pattern precisely. Coupling direct write printing with laser sintering would allow for the flexibility of drop-on-demand rapid prototyping, as well as the superior spatial resoluton of constrained laser sintering (S. H. Ko, H. Pan, C. P. Grigoropoulos, C. K. Luscombe, J. M. J. Frechet and D. Poulikakos, Nanotechnology, 2007, 18, 345202/345201-345202/345208; and M. Dietzel, N. R. Bieri and D. Poulikakos, Int. J. Heat Fluid Flow, 2008, 29, 250-262.) Not only is laser sintering a more selective way than bulk thermal sintering, but this technique offers much higher resolution as well. In the case of gold nanoparticles, line widths of 50 µm can be achieved using direct write printing followed by thermal sintering, whereas laser sintering allows for lines that are only 1-2 µm across. One heretofore disadvantage to this process has been the requirement of an additional instrument for the laser curing. First, the pattern must be printed using one device. Secondly, the substrate must be transferred to the laser sintering device, the position must be adjusted and then sintering is performed. The substrate transfer process from the printer to the laser sintering device means, that there is opportunity for the overlap of the printing and sintering pattern to lose their resolution, since the sample must be re-aligned. Furthermore, the need for a second device to perform the sintering automatically increases the cost of the instrumentation involved.

One device employing both inkjet printing and laser sintering has been reported in the literature (T. Y. Choi, D. Poulikakos and C. P. Grigoropoulos, Appl. Phys. Lett., 2004, 85, 13-15; and J. Tyrrell, "Laser sintering strikes gold with nanoparticle ink", http://nanotechweb.org/cws/article/tech/19932, Accessed Mar 24, 2009). In this work, a device that uses an inkjet printer to print a pattern onto a transparent glass substrate, with a focused laser beam projected upwards from below at the same target. While this configuration affords tandem inkjet and laser sintering within the same system, it has several drawbacks, including that is only applicable for substrates that are transprent and unaffected by large amount of laser irradiation - substrates that are opaque or laser sensitive cannot be used. Since the laser beam must pass through the substrate, if it absorbed any of the light, it may quickly heat up or degrade. Secondly, the system requires additional attention and engineering in the form of aligning the laser and inkjet systems to the exact same point in space, such that as the droplets are deposited, they are dried in place, and then sintered, one after another in a concerted fashion.

Another embodiment of a tandem sintering process has been recently disclosed in the public literature (J. Chung, N. R. Bieri, S. Ko, C. P. Grigoropoulos and D. Poulikakos, Appl. Phys. A: Mater. Sci. Process., 2004, 79, 1259-1261; N. R. Bieri, J. Chung, S. E. Haferl, D. Poulikakos and C. P. Grigoropoulos, Appl. Phys. Lett., 2003, 82, 3529-3531; and N. R. Bieri, J. Chung, D. Poulikakos and C. P. Grigoropoulos, Superlattices Microstruct., 2004, 35, 437-444). In this variation, the laser is fixed to a bench that is to the side of the printing stage, and aimed at an angle towards the sample, typically at an incidence angle of 45-60° relative to the plane of the substrate. This is done so that the laser does not get in the way of the print head or moving stage. There are several disadvantages to this layout. The first is that there is a distorted beam cross section, such that it is elliptical, rather than circular, and so all sintered features are biased along one direction. Secondly, the system requires additional attention and engineering with regards to laser alignment to the inkjet pattern, with the long working distance and angled nature of the beam making the task significantly morer challenging.

It has now been found that the efficiency of the preparation of printed and photonically treated electrically conducting surface patterns on a substrate can be improved if a direct write system with a laser device interconnected with the print head is used.

It is an object of the present invention to provide an improved fast, simple and cost-efficient technique that allows formation of photonically treated conductive surface patterns by treatment of printed structures with laser radiation.

The present invention relates to a process for photonically treating surface patterns on a substrate surface comprising the steps:
i) coating a surface of a substrate with a predetermined pattern of a photonically curable material by printing a fluid formulation of said photonically curable material with an inkjet printer onto said surface, and
ii) directing a laser beam generated by a laser interconnected with the print head of said inkjet printer to the substrate surface, whereby said laser beam impinges on the printed photonically curable material and causes said photonically curable material to become chemically modified and/or physically modified by the action of the laser radiation

The process of this invention uses at least one laser which is interconnected to the print head of the inkjet printer. Upon exposure of the laser radiation to the imprinted structure containing printed photonically curable material the energy of the laser beam will cause the printed photonically curable material to become modified in a very efficient manner.

In one embodiment of the process of this invention, the photonically curable material contains photocurable functional group, such as a combination of a freee radical photoinitiator and polymerizable vinyl groups. The laser radiation causes the photoinitiator to release free radicals, which cause the vinyl groups to polymerize. This chemical modification results in a polymer network forming from the original printed material.

In another embodiment of the process of this invention the photonically curable material is modified by the heat created by the absorption of the laser radiation in the imprinted material. If, for example, metal particles (or particles of other precursors of electrically conductive materials) are imprinted onto the substrate surface, the heat generated throughout the imprinted structures causes the particles to sinter or to anneal to form an electrically conducting pattern.

In another embodiment of the process of this invention, the process of this invention can be used to thermally heat materials to change the morphology of a given material, or to reduce or remove residual volatile components, such as solvents left over after printing. A large variety of photonically curable materials can be chosen for the method of this invention. The term "photonically curable material" is intended to encompass a material which undergoes a physical and/or chemical change upon the action of laser radiation.

As the laser is interconnected with the print head, the movement of the print head and of the laser are positionally synchronous, and the trace of photonically curable material formed by the printing process can be subsequently treated with the laser beam to form the final pattern of material on the surface. The deposition technique as well as the phototreatment of the laser radiation can be controlled by the same hardware and software, ensuring that each process overlaps as intended.

A large variety of substrates can be chosen for the method of this invention. Nonlimiting examples include polymers (thermoplastic and duroplastic polymers including elastomers); inorganic materials, such as ceramic materials; semiconducting substrates, such as silicon or gallium-arsenide, fibrous substrates containing natural and/or man-made fibers, such as paper, textile sheets including non-wovens; film and sheet materials made from polymers and or natural materials, such as leather, wood or thermoplastic sheet or bulk materials including composites containing said sheet or bulk materials.

Suitable substrates can possess a large variety of properties. For example, they can be transparent or non-transparent, or they can be crystalline or non-crystalline or they can contain additives, such as pigments, antistatic agents, fillers, reinforcing materials, lubricants, processing aids and heat and/or light stabilizers.

Preferred substrates are thermoplastic polymers, such as polyesters (e.g. polyethylene terephthalate), polyamides, polyimides, polyether-imides, polycarbonates, polyolefins (e.g. polyethylene or polypropylene), polyetherketones, polysiloxanes and polyarylenesulphides, such as polyphenylenesulphide.

Thus, a photonically curable material can be a chemical compound containing one or more moieties which can be activated by laser-radiation to undergo chemical reactions and to form different chemical compounds. Examples thereof are monomers, oligomers or polymers containing polymerizable groups which undergo polymerization reactions upon activation by laser radiation, either with or without the aid of a phoitoinitiator, or a catalyst such as a photosensitizer. Other examples thereof are groups which undergo other photochemical transitions upon activation by laser radiation, such as systems which undergo specific photochemical reactions, such as thiol-ene click couplings (L. M. Campos, K. L. Killops, R. Sakai, J. M. J. Paulusse, D. Damiron, E. Drockenmuller, B. W. Messmore and C. J. Hawker, Macromolecules, 2008, 41, 7063-7070.; and A. Dondoni, Angewandte Chemie-International Edition, 2008, 47, 8995-8997) or olefin cross photoadditions (K. Mizuno and Y. Otsuji, in Electron Transfer I, 1994, pp. 301-346), or photoaminations (T. Yamashita, J. Itagawa, D. Sakamoto, Y. Nakagawa, J. Matsumoto, T. Shiragami and M. Yasuda, Tetrahedron, 2007, 63, 374-380; and M. Yasuda, T. Yamashita, K. Shima and C. J. Pac, Journal of Organic Chemistry, 1987, 52, 753-759.) Other examples include the use of photosensitized cationic polymerizations to prepare polymeric photonic structures (S. Furumi, S. Yokoyama, A. Otomo and S. Mashiko, Thin Solid Films, 2003, 438, 423-427; P. V. Shivbaev, N. I. Boiko, A. Y. Bobrovskii and V. P. Shibaev, Polym. Sci. A, 2005, 47, 590-596; and T. J. White, L. V. Natarajan, V. P. Tondiglia, P. F. Lloyd, T. J. Bunning and C. A. Guymon, Macromolecules, 2007, 40, 1121-1127.) Other examples of photochemical processes which can be induced by a post-printing photonic processing of printed materials include the initiation and promotion of cadwelding and other aluminothermic and self-propagating high-temperature synthesis processes (K. J. Huang, X. Lin, C. S. Xie and T. M. Yue, Journal of Wuhan University of Technology-Materials Science Edition, 2008, 23, 89-94.; M. L. Mileham, M. P. Kramer and A. E. Stiegman, J. Phys. Chem. C, 2007, 111, 16883-16888; T. M. Yue, K. J. Huang and H. C. Man, Surf. Coat. Technol., 2005, 194, 232-237 ; T. M. Yue, K. J. Huang and H. C. Man, Surf. Eng., 2007, 23, 142-; and T. M. Yue, H. O. Yang, T. Li and K. J. Huang, Mater. Trans., 2009, 50, 219-221.)

Another group of photonically active materials are chemical compounds which undergo chemical and/or physical changes caused by the heat generated from the laser radiation absorbed by the imprinted surface pattern. The laser radiation may be absorbed by the chemical compound itself and/or by other components present in the imprinted structure. The heat may cause the chemical compound to melt, to sinter or to anneal and to form imprinted surface patterns with modified physical properties, such as imprinted surface patterns with improved electrical conductivity. Examples of this group of photonically active materials are particles of electrically conducting material dispensible by a direct writing technique in the form of a fluid suspension, or other suspended particles of a material that can be converted by heating into an electrically conducting material. Other examples of this group of photonically active materials are particles of semiconducting materials, such as silicon, germanium, cadmium sulfide, cadmium selenide, zinc sulfide, gallium arsenide or of hard materials, such as silicon nitride.

Another application would be selective laser ablation coupled with inkjet (S. H. Ko, J. Chung, H. Pan, C. P. Grigoropoulos and D. Poulikakos, Sens. Actuators, A, 2007, A134, 161-168; S. H. Ko, H. Pan, C. P. Grigoropoulos, J. M. J. Frechet, C. K. Luscombe and D. Poulikakos, Appl. Phys. A: Mater. Sci. Process., 2008, 92, 579-587; S. H. Ko, H. Pan, C. P. Grigoropoulos and D. Poulikakos, Proc. SPIE-Int. Soc. Opt. Eng., 2007, 6458, 645812/645811-645812/645818; S. H. Ko, H. Pan, D. J. Hwang, J. Chung, S. Ryu, C. P. Grigoropoulos and D. Poulikakos, J. Appl. Phys., 2007, 102, 093102/093101-093102/093109; and G. L. Williams, I. Wallhead, V. Sarojiniamma, P. A. Ivey and N. L. Seed, Sens. Actuators, A, 2004, A112, 360-367) wherein inkjet is used as an additive fabrication tool, while selective laser ablation is used afterwards to remove unwanted material, thus achieving higer printed feature resolution.

If electrically conducting surface patterns are desired, as a material forming the surface pattern in general each electrically conducting material or each material that can be converted by heating into an electrically conducting material can be used. Examples of materials which may be used for forming the surface pattern are metals, metal alloys, electrically conductive metal compounds, such as electrically conductive metal oxides or metal sulfides, electrically conducting polymers, or metal salts or metal complexes that can be readily converted into zerovalent metals during the drying and/or sintering process. Nonmetallic, main element-based materials include gallium, germanium, such as polycrystalline silicon, and different conductive allotropes of carbon, such as graphite, carbon nanotubes, and amorphous carbon, including functionalized/surface modified forms thereof. Other examples include polymer networks with adsorbed conductive electrolytes, including ionic liquids.

Examples of metals are noble metals, such as gold and/or silver, or metals from the groups 9, 10 and 11 of the periodic system of the elements; very preferred from these is copper.

An example for an electrically conductive metal oxide is indium tin oxide.

Examples of electrically conductive polymers are polythiophene, polypyrrole, polyacetylene, polyaniline, melanin, poly-(3,4-ethylenedioxythiophene), as well as conjugate materials such as poly-(3,4-ethylenedioxythiophene):polystyrenesulfonate, and the like. Still other preferred examples of conducting materials are electrolytes combined with a polymer and/or a prepolymer.

If electrically conducting metallic patterns are to be created, preferably, gold and especially preferred copper or silver or alloys containing silver and other metals are used. Mixtures of different metals can also be used.

When electrically conductive patterns are to be created, preferably the electrically conductive materials or the precursors to electrically conductive materials are applied in the form of a fluid formulation to the surface - either as purely liquid solutions, or as fluid emulsions, or as fluid suspensions of particles. The fluid formulation helps to develop predetermined surface patterns. In addition, it has been found that with very small particles (on the order of tens of nanometers or smaller), there is a significant decrease in the melting point temperature as well as the heat of fusion (K. S. Moon, H. Dong, R. Maric, S. Pothukuchi, A. Hunt, Y. Li and C. P. Wong, J. Electron. Mater., 2005, 34, 168-175), which means that the amount of heat input needed to melt or anneal the particles and process them into a single, continuous structure is greatly reduced. While this phenomenon is known for materials semiconductors and covalently bonded materials (H. H. Farrell and C. D. Van Siclen, Journal of Vacuum Science & Technology B, 2007, 25, 1441-1447; and A. F. Lopeandia and J. Rodriguez-Viejo, Thermochimica Acta, 2007, 461, 82-87), the melting point depression phenomenon is far more pronounced for metallic and ionic materials as their size decreases (M. Takagi, J. Phys. Soc. Jpn., 1954, 9, 359-363; M. Mirjalili and J. Vahdati-Khaki, J. Phys. Chem. Solids, 2008, 69, 2116-2123; M. Zhang, M. Y. Efremov, F. Schiettekatte, E. A. Olson, A. T. Kwan, S. L. Lai, T. Wisleder, J. E. Greene and L. H. Allen, Phys. Rev. B: Condens. Matter Mater. Phys., 2000, 62, 10548-10557; A. Q. Jiang, N. Awasthi, A. N. Kolmogorov, W. Setyawan, A. Borjesson, K. Bolton, A. R. Harutyunyan and S. Curtarolo, Phys. Rev. B: Condens. Matter Mater. Phys., 2007, 75, 205426; J. Sun and S. L. Simon, Thermochimica Acta, 2007, 463, 32-40; P. R. Couchman and W. A. Jesser, Nature (London), 1977, 269, 481-483; and G. L. Allen, R. A. Bayles, W. W. Gile and W. A. Jesser, Thin Solid Films, 1986, 144, 297-308.)

Typical mean particle diameters are in a range between 1 nm and 100µm, preferably 1 nm - 1 µm, very preferred 1 nm - 50 nm and especially preferred 1 nm - 10 nm. The mean particle diameter is determined by transmission electron microscope, scanning electron microscopy, or by dynamic light scattering, photon correlation spectroscopy, analytical ultracentrifugation, atomic force microscopy, laser diffraction, quasi-elastic light scattering, or by UV-VIS spectroscopy.

If electrically conductive lines are the goal, very preferably, metal nanoparticles are used which allow the formation of conducting surface patterns with minimum amount of laser beam energy.

In the process of this invention, a laser beam is used which is generated by a laser interconnected with the print head of the inkjet printer. The selection of the laser is not specificially limited. Suitable lasers must be capable to become interconnected with the print head. Thus, suitable lasers must be selected with respect of form and weight to be combined with the print head in a manner that the function of these devices is not adversely affected.

The laser can be mounted into the print head or, alternatively, can be combined with the print head in any other manner. Preferably the laser is combined with an adjusting device which allows adjustment of the focus of the laser beam.

The critical feature of the nature of the actinic laser radiation is that it is capable to cause the photonic material printed on the surface to become modified in the intended manner by the action of the laser radiation. Typically, laser radiation of wavelengths between 150 and 1100 nm are selected.

Preferably the laser is selected from a Q-switched Nd-YAG laser, a frequency doubled Nd-YAG laser, an argon ion laser, a krypton laser, a helium-neon laser, or a carbon dioxide laser.

The nature of the ink is not critical, as long as this permits inkjet printing of the photonically curable material onto the surface. Examples of inks are solutions, suspensions or dispersions of photonically curable material in a solvent, suspension agent or dispersion agent.

If conductive particles are used, or if particles of a material which can be converted by heating into a conducting material are used, the surface of the substrate is preferably coated with said particles by inkjet printing a dispersion containing said particles in a liquid onto said surface.

Predetermined surface patterns can be layers covering the whole surface, or other forms of surface coverage. Preferably, surface patterns cover portions of the surface, for example in the form of tracks and/or of isolated spots of photonically active material, such as metal particles. Several surfaces of the substrate can be coated. For example, two surfaces of a sheet material can be coated in the form of tracks, which are optionally connected via holes going through the substrate and containing conductive material.

Initially, the coating material that forms the patterns on said surface is present as a solution, suspension or dispersion of the photonically curable material in a carrier material that renders the coating material fluid. This fluid coating material is a printable fluid hereinafter referred to as "ink".

The ink is applied to the surface of the substrate by means of a direct write technique, such as inkjet printing, and forms a pattern after drying.

When applying the ink to the surface of the substrate, the carrier material can be removed at the same time by simply allowing the carrier material to evaporate. This can be accelerated, for example, by using a substrate at elevated temperatures and by chosing a carrier material that evaporates or decomposes at the substrate temperature. In an alternative or an additional step, the carrier material can be evaporated or decomposed after the printing of the photonically curable material by the laser radiation impinging on to the imprinted surface immediately after the printing step.

Immediately after a predetermined pattern of a photonically curable material that can be converted by actinic laser radiation into a modified material has been formed by inkjet printing on the substrate surface, this is exposed for a selected time to laser radiation of selected power. The treatment time of the laser beam is controlled by the speed of the print head of the inkjet printer. The laser beam may be continuous or pulsed. The light may be polarized or non-polarized, and the beam shape may either be a singular, symmetrical spot, or a more complex pattern. Furthermore, the laser beam may be synchronized with the print head in a manner that the laser emits a laser beam only when the print head is active.

After the printing and laser treatment, the coated substrate can be heated additionally, for example in an oven or by treatment with microwave radiation.

The processed substrates containing surface patterns of modified photonically curable material can be compiled to form a layered product with several substrates possessing patterns of modified photonically curable material in the interior and on the surface. The layered products can contain layers of other materials besides the processed substrates containing surface patterns of modified photonically curable material.

The equipment for performing the method of this invention can be chosen from known equipment. Inkjet printers and lasers are known in the art and commercially available.

But the combination of these devices has not been used yet and is also object of this invention. The invention also relates to a device for performing the above-defined method. This device is characterized by comprising at least one laser and an inkjet printer equipped with at least one print head, wherein the laser is interconnected with with the print head.

Preferred devices of this invention contain an adjusting device, which allows adjustment of the direction of the laser radiation emitted by the laser.

In a preferred variant of the device of this invention, the laser is mounted into the print head.

The process for generating photonically cured or processed surface patterns, preferably conductive surface patterns, on a substrate surface can be used, for example, for the production of printed wiring boards, of integrated circuits, of decorative sheets, of data recording or of data storing media, print boards, of radio frequency identification tags (RFID tags), of organic light emitting devices (OLED), of thin-film transistors (TFT), of electrical devices, like heating elements, resistors, coils or antennae, of displays, of smart packages, of flexible circuits, of sensors or of photovoltaic devices. This same approach can be used for preparing surface patterns that are ionically conductive, such as for printed components for batteries or power sources. This can also be used to create patterns to be used to create other functional surface patterns, including optical gratings (M. O. Jensen and M. J. Brett, J. Nanosci. Nanotechnol., 2005, 5, 723-728; P. Janda, J. Valenta, T. Ostatnicky, E. Skopalova, I. Pelant, R. G. Elliman and R. Tomasiunas, J. Lumin., 2006, 121, 267-273), and planar waveguides (J. L. Zhao, B. L. Li, P. Zhang, D. X. Yang and Z. W. Li, Acta Phys. Sinica, 2004, 53, 2583-2588).

These uses are also object of the present invention.

## Claims

1. A process for for photonically treating surface patterns of a photonically curable material printed on a substrate surface comprising the steps
i) coating a surface of a substrate with a predetermined pattern of a photonically curable material said photonically curable material with an inkjet printer onto said surface, and
ii) directing a laser beam generated by a laser interconnected with the print head of said inkjet printer to the substrate surface whereby said laser beam impinges on the printed photonically curable material and causes said photonically curable material to become chemically modified and/or physically modified by the action of the laser radiation modify the printed pattern.

2. A process as claimed in claim 1, wherein the photonically curable material contains photocurable groups and the laser radiation causes these groups to cure and to form a chemically modified material on the substrate surface.

3. A process as claimed in claim 1, wherein the photonically curable material is modified by the energy absorption from the laser radiation in the imprinted material.

4. A process as claimed in claim 3, wherein the photonically curable material contains particles of conducting material and/or particles of a material that can be converted by heating into an conducting material.

5. A process as claimed in claim 4, wherein the conducting material is a metal, an electrically conducting polymer or an conducting metal oxide.

6. A process as claimed in claim 4, wherein the surface of the substrate is coated with with a predetermined pattern of metal particles and/or by particles of an conducting metal oxide, preferably by applying a dispersion containing said metal particles and/or containing said electrically conducting metal oxide particles in a liquid onto said surface, and optionally drying said coated substrate to cause said liquid to evaporate.

7. A process as claimed in claim 7, wherein the metal is gold, silver, copper or a combination thereof, preferably silver.

8. A process as claimed in claim 4, wherein the conducting material is an electrolyte and a polymer or a prepolymer.

9. A process as claimed in any of the claims 4 to 7, wherein the particles possess a mean particle diameter between 1 nm and 100 µm, especially preferred between 1 nm and 50 nm.

10. A process as claimed in any of the claims 1 to 9, wherein the laser is selected from devices producing laser radiation of wavelengths between 150 and 1100 nm.

11. A process as claimed in claim 10, wherein the laser is selected from a Q-switched Nd-YAG laser, a frequency doubled Nd-YAG laser, an argon ion laser, a krypton laser, a helium-neon laser, or a carbon dioxide laser.

12. A device for performing the method according to claim 1 comprising at least one laser and an inkjet printer equipped with at least one print head, wherein the laser is interconnected with with the print head.

13. A device according to claim 12, wherein the direction of the laser radiation emitted by the laser can be adusted by means of an adjusting device.

14. A device as claimed in claims 12 or 13, wherein the laser is selected from a Q-switched Nd-YAG laser, a frequency doubled Nd-YAG laser, an argon ion laser, a krypton laser, a helium-neon laser, or a carbon dioxide laser.

15. A device as claimed in claims 12 to 14, wherein the laser is mounted into the print head.

16. Use of the process according to any of the claims 1 to 11 for the production of printed wiring boards, of integrated circuits, of decorative sheets, of data recording or of data storing media, of print boards, of radio frequency identification tags, of organic light emitting devices, of thin-film transistors, of electrical devices, of displays, of smart packages, of flexible circuits, of sensors or of photovoltaic devices.
